Europäisches Patentamt

European Patent Office

Office européen des brevets

(11) Veröffentlichungsnummer: **0 208 911**
**A1**

# EUROPÄISCHE PATENTANMELDUNG

(21) Anmeldenummer: 86107921.8

(22) Anmeldetag: 10.06.86

(51) Int. Cl.4: **H01L 29/743**

Die Bezeichnung der Erfindung wurde geändert (Richtlinien für die Prüfung im EPA, A-III, 7.3).

(30) Priorität: 11.06.85 DE 3520901

(43) Veröffentlichungstag der Anmeldung:
**21.01.87 Patentblatt 87/04**

(84) Benannte Vertragsstaaten:
**CH DE FR GB IT LI SE**

(71) Anmelder: **Siemens Aktiengesellschaft Berlin und München**
**Wittelsbacherplatz 2**
**D-8000 München 2(DE)**

(72) Erfinder: **Lehmann, Erhard, Dipl.-Ing.**
**Römerstrasse 58**
**D-8011 Aschheim(DE)**
Erfinder: **Voss, Peter, Dr.**
**Rudliebstrasse 42**
**D-8000 München 81(DE)**

(54) **Elektronischer Halbleiterschalter.**

(57) Ein abschaltbarer Thyristor (1) kann durch Kurzschließen von Gate-und Katodenleitung abgeschaltet werden. Dies geschieht durch ein steuerbares Halbleiterbauelement (3), das einerseits an die Gateleitung und andererseits an den Katodenanschluß einer Diode (2) angeschlossen ist, die ihrerseits dem abschaltbaren Thyristor katodenseitig in Reihe geschaltet ist. Damit lassen sich also kurzschließendes steuerbares Halbleiterbauelement bipolare Leistungshalbleiterbauelemente mit einer dem Thyristor entsprechenden Stromtragfähigkeit oder MOS-Halbleiterbauelemente mit höheren Durchlaßspannungen verwenden.

FIG1

FIG 3

EP 0 208 911 A1

## Elektronischer Schalter

Die vorliegende Erfindung bezieht sich auf einen elektronischen Schalter mit einem abschaltbaren Thyristor mit einem Katodenanschluß und einem Gateanschluß und mit einem steuerbaren Halbleiterbauelement, dessen Laststrekke am Gateanschluß angeschlossen ist.

Ein Schalter dieser Gattung ist beispielsweise in der DE-OS 31 18 353 beschrieben worden. Das steuerbare Halbleiterbauelement ist beim bekannten elektronischen Schalter ein MOSFET, dessen Drain-Source-Strecke, d. h. Laststrecke, zwischen dem Katodenanschluß und dem Gateanschluß angeschlossen ist. Der Gateanschluß seinerseits ist mit einer feinstrukturierten über die Oberfläche der p-Basisschicht verteilten Elektrode verbunden. Ein Thyristor dieser Art kann durch Kurzschließen des Katodenanschlusses mit dem Gateanschluß, d. h. durch Leitendsteuern des MOSFET gelöscht werden. Dazu muß ein MOSFET verwendet werden, dessen Durchlaßwiderstand im eingeschalteten Zustand kleiner als diejenige Spannung ist, bei der der katodenseitige Emitter-Basis-pn-Übergang noch nicht emittiert. Diese liegt bei ca. 0,5 V. Dabei muß der MOSFET in der Lage sein, mindestens 1/10 des Thyristorstroms kurzzeitig bis zum Erlöschen des GTO-Thyristors zu führen. Zum Löschen von abschaltbaren Thyristoren mit großer Leistung kommen daher MOSFETs nur dann in Frage, wenn der Spannungsabfall im MOSFET und in seinen Zuleitungen unter 0,5 V bleibt. Bipolare Halbleiterbauelemente hoher Stromtragfähigkeit können hier nicht eingesetzt werden, da deren Durchlaßspannung im allgemeinen über den oben genannten 0,5 V liegt.

Der Erfindung liegt die Aufgabe zugrunde, einen Schalter der beschriebenen Art so weiterzubilden, daß der abschaltbare Thyristor auch dann gelöscht werden kann, wenn der Spannungsabfall im kurzschließenden Halbleiterbauelement und seinen Zuleitungen über 0,5 V liegt.

Dies wird durch die folgenden Merkmale erreicht:

a) dem abschaltbaren Thyristor ist katodenseitig eine Diode in Reihe geschaltet,

b) die Laststrecke des steuerbaren Halbleiterbauelements ist zwischen dem Gateanschluß des abschaltbaren Thyristors und dem Katodenanschluß der Diode angeschlossen,

c) die Durchlaßspannung des steuerbaren Halbleiterbauelements ist niedriger als die Summe der Spannung des katodenseitigen Emitter-Basis-pn-Übergangs des abschaltbaren Thyristors zuzüglich der Durchlaßspannung der Diode.

Mit der erfindungsgemäßem Lösung wird durch die in Reihe geschaltete Diode die Durchlaßspannung im Lastkreis erhöht. In vielen Fällen, z. B. bei Stellern und Stromrichtern spielen jedoch die durch die Halbleiterbauelemente hervorgerufenen Verluste gegenüber den Verlusten im Löschkreis und in der Beschaltung eine nur untergeordnete Rolle. Diese Verluste erhöhen sich durch die in Serie geschaltete Diode gemessen an den sonstigen Kreisverlusten nur unwesentlich.

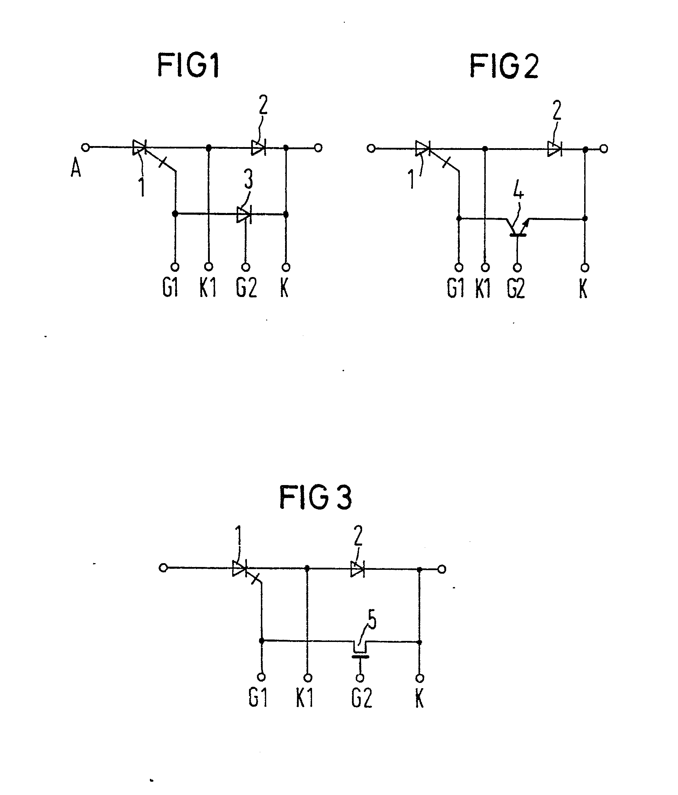

Die Erfindung wird anhand zweier Ausführungsbeispiele in Verbindung mit den Fig. 1 bis 3 näher erläutert. Die Figuren zeigen Prinzipschaltbilder mit einem Thyristor, einem Bipolartransistor und einem MOSFET als steuerbaren Halbleiterbauelementen.

Der elektronische Leistungsschalter nach Fig. 1 besteht aus einem abschaltbaren Thyristor 1, dem auf der Katodenseite eine Diode 2 in Reihe geschaltet ist. Zwischen dem Gateanschluß G 1 und dem Katodenanschluß der Diode ist ein Thyristor 3 angeschlossen. Der Thyristor 3 ist so gepolt, daß der Gatestrom des abschaltbaren Thyristors 1 beim Leitendsteuern von Thyristor 3 zum Katodenanschluß K abfließen kann. Der Thyristor 3 ist so dimensioniert, daß er während des Abschaltvorgangs den notwendigen Gatestrom des abschaltbaren Thyristors 1 aufnehmen kann. Dieser liegt je nach dem Aufbau des abschaltbaren Thyristors 1 zwischen dem 0,1-und dem 1,0 fachen seines Anodenstroms. Der Thyristor 3 hat dabei eine Durchlaßspannung $U_F$ in Flußrichtung, die kleiner ist als die Summe der oben erwähnten 0,5 V des Thyristors 1 zuzüglich der Durchlaßspannung $U_F$ der Diode 2. Hierbei müssen auch die Widerstände der Zuleitungen zum Thyristor 3 berücksichtigt werden. Der Thyristor 3 kann dementsprechend je nach $U_F$ der Diode eine Durchlaßspannung $U_F$ von etwa 1,2 und V haben.

Der elektronische Schalter ist zusätzlich noch mit einer Klemme K 1 versehen, die zwischen dem Katodenanschluß des abschaltbaren Thyristors 1 und dem Anodenanschluß der Diode 2 liegt. Der Thyristor 1 wird durch Einspeisen eines Stromimpulses zwischen den Anschlüssen G 1, K 1 eingeschaltet.

Der elektronische Schalter nach Fig. 2 unterscheidet sich von dem nach Fig. 1 dadurch, daß der Thyristor 3 hier durch einen Bipolartransistor 4 ersetzt ist. Der Bipolartransistor 4 ist ein Transistor mit geringer Restspannung, d. h. vorzugsweise ein Schalttransistor. Der Thyristor 1 wird in diesem Fall durch Leitendsteuern des Bipolartransistors 4 am Anschluß G 2 gelöscht.

In Fig. 3 ist eine Abwandlung des elektronischen Leistungsschalters gezeigt, bei dem als kurzschließendes Halbleiterbauelement ein Leistungs-MOSFET 5 verwendet ist.

Für den Thyristor 3, den Bipolartransistor 4 und dem MOSFET 5 gilt, daß deren maximale Sperrspannung nur geringfügig größer sein muß als die maximale Basis-Emitter-Sperrspannung des abschaltbaren Thyristors 1. Diese liegt im allgemeinen zwischen 10 und 25 V.

Statt eines Thyristors, eines Bipolartransistors oder eines MOSFET kann auch ein sogenannter statischer Induktionsthyristor (SIT) mit entsprechend niedriger Durchlaßspannung verwendet werden. Ein solcher Thyristor ist aus der Literatur bekannt, seine Funktionsweise wird daher nicht besonders erläutert.

Soll der elektronische Schalter auch in Rückwärtsrichtung sperren, so kann es zweckmäßig sein, die Diode und das kurzschließende Bauelement so auszulegen, daß die Sperrwirkung in Rückwärtsrichtung von diesen übernommen wird.

## Ansprüche

1. Elektronischer Schalter mit einem abschaltbaren Thyrikstor mit einem Katodenanschluß und einem Gateanschluß und mit einem steuerbaren Halbleiterbauelement, dessen Laststrecke am Gateanschluß angeschlossen ist, **gekennzeichnet** durch die Merkmale:

a) dem abschaltbaren Thyristor (1) ist katodenseitig eine Diode (2) in Reihe geschaltet,

b) die Laststrecke des steuerbaren Halbleiterbauelements (3) ist zwischen dem Gateanschluß (G 1) des abschaltbaren Thyristors und dem Katodenanschluß (K) der Diode angeschlossen,

c) die Durchlaßspannung des steuerbaren Halbleiterbauelements ist niedriger als die Summe der Spannung des katodenseitigen Emitter-Basis-pn-Übergangs des abschaltbaren Thyristors zuzüglich Durchlaßspannung der Diode.

2. Elektronischer Schalter nach Anspruch 1, **dadurch gekennzeichnet**, daß das steuerbare Halbleiterbauelement ein Bipolartransistor (4) ist.

3. Elektronischer Schalter nach Anspruch 1, **dadurch gekennzeichnet**, daß das steuerbare Halbleiterbauelement ein Thyristor (3) ist.

4. Elektronischer Schalter nach Anspruch 1, **dadurch gekennzeichnet**, daß das steuerbare Halbleiterbauelement ein MOSFET (5) ist.

5. Elektronischer Schalter nach Anspruch 1, **dadurch gekennzeichnet**, daß das steuerbare Halbleiterbauelement ein statischer Induktionsthyristor (SIT) ist.

6. Elektronischer Schalter nach einem der Ansprüche 1 bis 5, **dadurch gekennzeichnet**, daß das steuerbare Halbleiterbauelement eine maximale Sperrspannung hat, die nur geringfügig größer als die maximale Basis-Emitter-Sperrspannung des abschaltbaren Thyristors ist.

# FIG1

# FIG2

# FIG 3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | EP-A-0 106 059 (SIEMENS AG) <br> * Zusammenfassung; Ansprüche 1,2 * <br><br> --- | 1,4 | H 01 L 29/743 |
| A | DE-A-2 945 391 (SIEMENS AG) <br> * Ansprüche 1,6; Figur 1 * <br><br> --- | 1,4 | |
| D,A | DE-A-3 118 353 (SIEMENS AG) <br> * Zusammenfassung * <br><br> --- | 1,4 | |
| A | DE-A-2 825 794 (LICENTIA PATENT-VERWALTUNGS-GmbH) <br> * Seite 8, Absatz 3; Figur 1B * <br><br> --- | 1,4 | |
| A | FR-A-2 443 172 (OKI ELECTRIC INDUSTRY CO. LTD. & NIPPON TELEGRAPH AND TELEPHONE PUBLIC CORP.) <br> * Figur 3 * <br><br> ----- | 1,4 | RECHERCHIERTE SACHGEBIETE (Int. Cl.4) <br><br> H 01 L |

Der vorliegende Recherchenbericht wurde für alle Patentansprüche erstellt.

| Recherchenort | Abschlußdatum der Recherche | Prüfer |
|---|---|---|
| DEN HAAG | 09-09-1986 | ZOLLFRANK G.O. |